# EUROPEAN PATENT APPLICATION

(11) **EP 2 639 574 A1**
(43) Date of publication of application: **18.09.2013**
(21) Application number: 13157774.4
(22) Date of filing: 05.03.2013
(51) Int. Cl.: G01N 21/94

(54) **Apparatus for monitoring insulators of an overhead electric power line**

(30) Priority: 16.03.2012 IT MI20120411
(71) Applicant: Ricerca Sul Sistema Energetico - RSE S.p.A., 20134 Milano (IT)
(72) Inventor: Perini, Umberto, 26854 Pieve Fissiraga - Lodi (IT); Golinelli, Elena, 20131 Milano (IT); Musazzi, Sergio, 20025 Legnano (IT)
(74) Representative: Martegani, Franco

(57) **Abstract**

An apparatus (1) for the monitoring of insulators of an overhead electric power line, comprises an optical measurement unit (4) of the salt contamination of an insulator simulacrum (2) of said electric power line, said unit (4) being suitable for emitting a laser (6) beam (F) suitable for striking said simulacrum (2); detection and analysis means (9) of the light radiation (F') emitted by the plasma generated on the surface of said simulacrum (2); covering and containment means (11,12) of said optical control unit (4); and movement means (10) of said simulacrum (2) suitable for rotating and moving the simulacrum (2) itself towards and away from the interior of said covering and containment means (11,12).

## Description

The present invention relates to an apparatus for monitoring the surface pollution level of insulators of an overhead electric power line.

In particular, the present invention is advantageously used for monitoring the presence of salt formations or accumulations deposited on the insulators of an overhead electric power line, to which the following description will make explicit reference, at the same time maintaining its generic characteristics, and specifically relates to an electro-optical apparatus for controlling and measuring the saline deposit on a voltage-free insulator simulacrum consisting of three insulators identical to those forming the insulating chain actually installed on the line, and situated on a pylon of the line itself, typically in an area close to the operating insulators.

As is known, the deposit of sea salt on the insulators of an electric power line is a critical element for the continuity of the electric supply, as it can lead to a reduction in the electrical insulation, in particular in the presence of considerable environmental humidity or even light rainfall.

For this reason, in order to prevent electric discharge phenomena, periodical washings of the insulators are envisaged, especially on lines close to coastal areas, effected by skilled operators and, in some cases, without interrupting the operability of the electric power line.

In order to reduce the onerous nature of these maintenance and cleaning operations, it is important to previously evaluate the formation of saline deposits of such a degree as to represent a potential risk of discharges.

Methods using detections in loco of the accumulation of saline deposits are currently available on insulator models or simulacrums identical to those actually operating and under live voltage.

These methods generally involve the use of insulator simulacrums having a different form from that of the actual insulators being examined, and their positioning, in view of the dimensions of the measurement systems, on ground level.

An objective of the present invention is to solve and overcome the problems of the known art indicated above.

In particular, an objective of the present invention is to provide an apparatus capable of monitoring, in real time, the formation of accumulations of salt or similar polluting materials on insulators of an overhead electric power line.

A further objective of the present invention is to provide a monitoring apparatus of insulators of an electric power line that is reliable with respect to the safety regulations in force.

The structural and functional characteristics of the present invention and its advantages with respect to the known art will appear more evident from the claims provided hereunder, and in particular from the following description, referring to the enclosed drawings, which show the schematization of a preferred but non-limiting embodiment of an apparatus for the monitoring of insulators of an overhead electric power line, in which:
- figure 1 represents a schematic view of the monitoring apparatus object of the invention;
- figure 2 is a front schematic view of the apparatus of figure 1 in a first operative position; and
- figure 3 is a front schematic view of the apparatus of figure 1 in a second operative position.

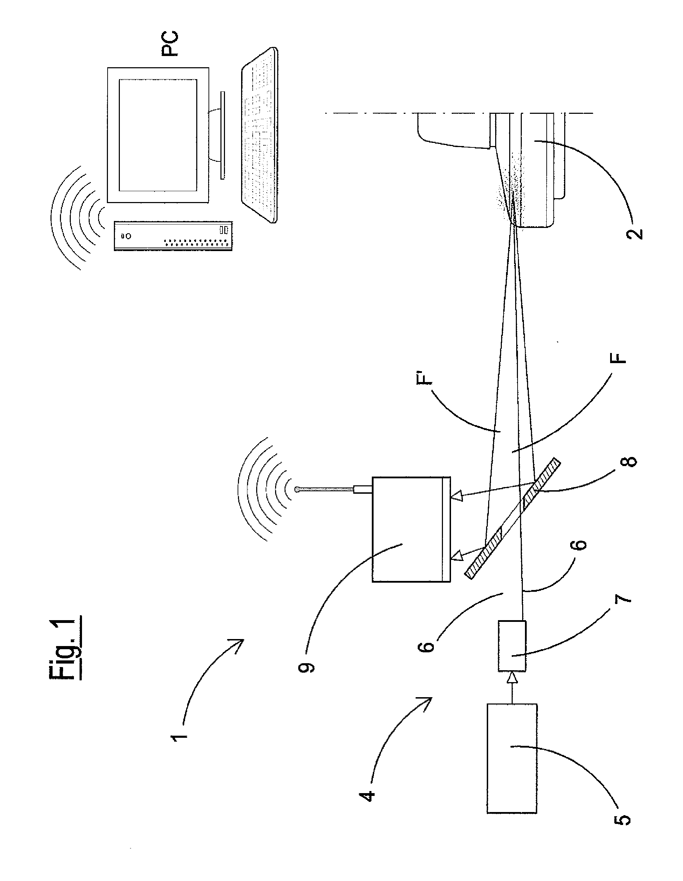

With reference to figure 1, the number 1 indicates as a whole an apparatus for the monitoring of an insulator simulacrum 2 corresponding to those operating on an overhead electric power line (known and not illustrated).

The apparatus 1 is preferably installed on a pylon at a height similar to that of the operating insulators, and is able to operate autonomously and effect measurements at preselected time intervals in different areas of the simulacrum 2.

The apparatus 1 specifically comprises an optical measurement unit 4 of the contamination state of the simulacrum 2 and which is defined by a source 5 of laser radiation emission 6 suitable for being directed in the form of a beam F from an optical group 7 towards the simulacrum 2 after passing through a centrally pierced mirror 8.

The laser radiation 6 from the source 5 is emitted with pulses having a certain energy and peak power so as to produce plasma, consisting of ionized atoms of the material present on the surface of the insulator, in the region of the simulacrum 2 struck by the beam F.

In this way, the return light radiation F' emitted by the plasma which is generated on the simulacrum 2 is suitable for being intercepted by the mirror 8 and reflected on a detection device 9, both forming part of the unit 4.

The unit 4 also comprises its own battery supply group (not illustrated) and a panel equipped with photovoltaic cells (also not illustrated).

Using a known technology (*LIBS - Laser Induced Breakdown Spectroscopy*), in relation to the radiation intensity F' emitted by the plasma which is generated on the simulacrum 2 and the number of pulses necessary for cleaning the surface of the simulacrum 2, it is therefore possible to reveal the presence and quantity of salt accumulated on the simulacrum 2 itself exposed to an outside environment.

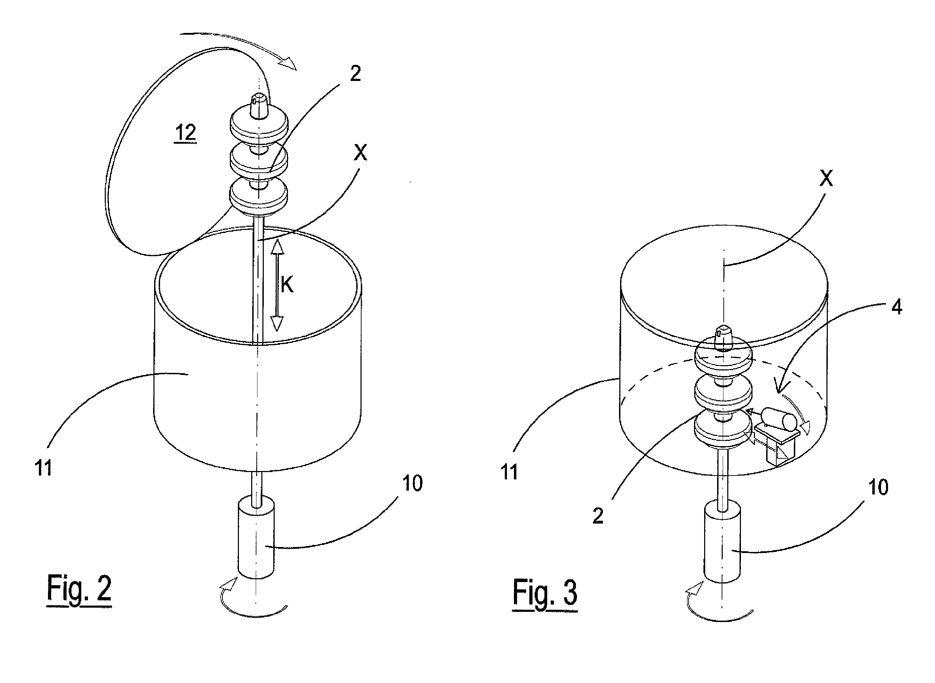

According to what is illustrated in figures 2 and 3, the apparatus 1 also comprises a movement motor group 10 suitable for rotating the simulacrum 2 around a vertical axis X, so as to expose the whole outer peripheral surface of the same simulacrum 2 to the pulsed 6 laser beam F emitted by the source 5 of the unit 4.

The group 10 is also suitable for moving the simulacrum 2 in a vertical direction K along the axis X towards and away from the interior of a cylindrical container 11, preferably made of aluminum, equipped with a closing lid 12 (figure 2).

According to what is better illustrated in figure 3, the cylinder 11 is also suitable for containing the whole unit 4, so that, when in use, the simulacrum 2 is situated inside the chamber defined by the cylindrical container 11 closed by the lid 12, only during the measurement of the salt contamination, whereas it is situated outside the cylindrical container 11 for most of the time, so as to reproduce the same atmospheric conditions as the insulators actually operating.

The apparatus 1 also comprises a computer PC remote-connected, for example by means of a wireless connection, to the detection device 9 of the unit 4 to receive and process the data sent by the detection device 9 itself.

The computer PC is situated outside the cylindrical container 11 (Figure 1).

An apparatus is therefore obtained, which is capable of monitoring, in real time, the formation of accumulations of salt or similar contaminating materials on the insulators of an overhead electric power line, which is reliable and respects the safety regulations in force.

## Claims

1. An apparatus (1) for monitoring insulators of an overhead electric power line, **characterized in that** it comprises an optical control unit (4) of the salt contamination of an insulator simulacrum (2) of said electric power line, said unit (4) being suitable for emitting a pulsed laser (6) beam (F) for striking said simulacrum (2); means (9) for the detection and analysis of a light beam (F') emitted from the plasma generated on the surface of said simulacrum (2); covering and containment means (11,12) of said optical monitoring unit (4), and supporting and movement means (10) of said simulacrum (2), said supporting means (10) being suitable for supporting and moving said simulacrum (2) towards and away from the interior of said covering and containment means (11,12).

2. The apparatus according to claim 1, **characterized in that** said unit (4) comprises an emission source (5) of pulsed laser radiation (6); a focalization group (7) of said beam (F) and pierced mirror means (8) being envisaged to allow the passage of said beam (F) towards said simulacrum (2).

3. The apparatus according to claim 2, **characterized in that** said mirror means (8) are suitable for reflecting the light radiation (F') generated by the plasma towards said detection and control means (9).

4. The apparatus according to one of the previous claims 1 to 3, **characterized in that** it also comprises display means (PC) connected to said detection means (9) for visualizing and managing the data sent from said detection means (9).

5. The apparatus according to one of the previous claims 1 to 4, **characterized in that** said covering means (11,12) comprise a cylinder (11) provided with a lid (12).

6. The apparatus according to claim 5, **characterized in that** said cylinder (11) is made of aluminum or other material opaque to laser radiation.

7. The apparatus according to one of the previous claims 1 to 6, **characterized in that** said supporting and movement means (10) of said simulacrum (2) comprise motor means (10) suitable for rotating said simulacrum (2) around an axis (X), so as to expose the whole outer peripheral surface of said simulacrum (2) to said beam (F) of pulsed laser rays (6), and suitable for moving said simulacrum (2) in a direction (K) towards said covering means (11,12).
